# FASCICULE DE BREVET EUROPEEN

(11) **EP 3 039 438 B1**
(45) Date de publication et mention de la délivrance du brevet: **16.05.2018**
(21) Numéro de dépôt: 14755692.2
(22) Date de dépôt: 27.08.2014
(51) Int. Cl.: G01R 31/40

(54) **DÉTECTION D'UN ARC ÉLECTRIQUE EN PARALLÈLE SUR LES BORNES PRINCIPALES D'UNE INSTALLATION PHOTOVOLTAÏQUE**
PARALLELE LICHTBOGENERFASSUNG ÜBER DIE HAUPTANSCHLÜSSE EINER FOTOVOLTAIKANLAGE
PARALLEL ELECTRIC ARC DETECTION ACROSS THE MAIN TERMINALS OF A PHOTOVOLTAIC INSTALLATION

(30) Priorité: 29.08.2013 FR 1358269
(43) Date de publication de la demande: 06.07.2016
(73) Titulaire: Commissariat à l'Énergie Atomique et aux Énergies Alternatives, 75015 Paris (FR)
(72) Inventeur: CHAINTREUIL, Nicolas, F-73800 Montmelian (FR); PLISSONNIER, Alexandre, F-38800 Pont-de-Claix (FR)
(74) Mandataire: Brevalex
(86) Numéro de dépôt international: PCT/EP2014/068164
(87) Numéro de publication internationale: WO 2015/028505

(56) Documents cités:
- US-A1- 2011 141 644
- SCHIMPF F ET AL: "Recognition of electric arcing in the DC-wiring of photovoltaic systems", TELECOMMUNICATIONS ENERGY CONFERENCE, 2009. INTELEC 2009. 31ST INTERNATIONAL, IEEE, PISCATAWAY, NJ, USA, 18 octobre 2009 (2009-10-18), pages 1-6, XP031579534, ISBN: 978-1-4244-2490-0
- RICHARD MEHL ET AL: "High voltage DC protection of high voltage DC next generation smart datacom power distribution with solid state hybride circuit breakers and arc fault detection modules (AFDM)", TELECOMMUNICATIONS ENERGY CONFERENCE (INTELEC), 2012 IEEE 34TH INTERNATIONAL, IEEE, 30 septembre 2012 (2012-09-30), pages 1-6, XP032276433, DOI: 10.1109/INTLEC.2012.6374482 ISBN: 978-1-4673-0999-8

## Description

### DOMAINE TECHNIQUE ET ART ANTERIEUR

L'invention concerne les installations photovoltaïques et, en particulier, les moyens de détection d'arcs électriques dans ces installations.

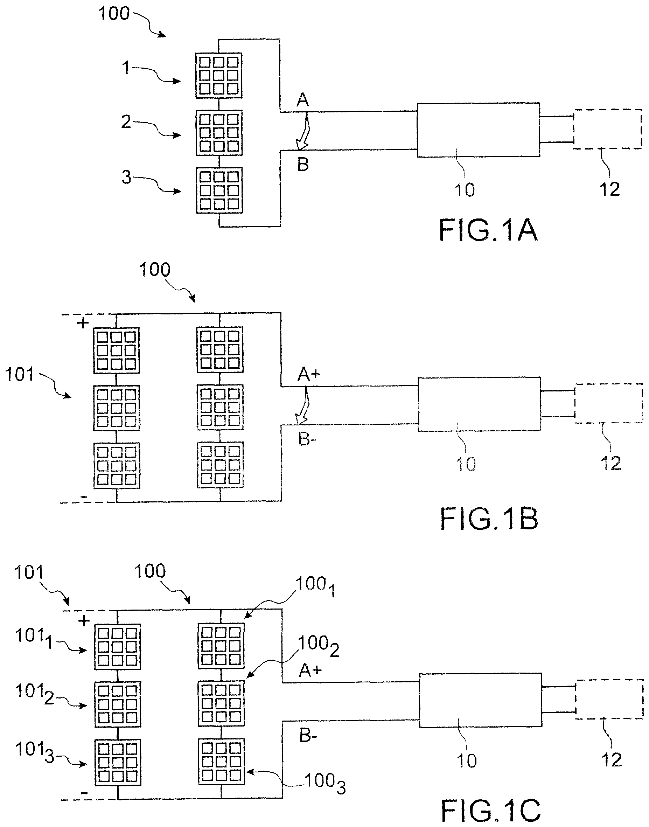

Les installations utilisant des panneaux photovoltaïques (PV) sont appelées à se développer. Or ce type de dispositif vieillit et des défaillances peuvent apparaître au cours du temps. Celles-ci peuvent être bénignes (par exemple : arrêt de fonctionnement, perte de production, baisse du rendement...) mais peuvent aussi être plus graves si un arc électrique parallèle apparaît. En effet, la conséquence d'un tel phénomène peut être, dans le pire des cas, un départ d'incendie pouvant aller jusqu'à la destruction du bâtiment dans lequel un module PV est installé. Un arc parallèle s'établit entre des points ou des zones à des potentiels différents. Le document US2011/141644A décrit un procédé pour détecter un arc dans un'installation photovoltaïque. La figure 1A représente une installation la photovoltaïques de type connu, avec une chaine 100 de 3 modules photovoltaïques 1, 2, 3 et un convertisseur (ou onduleur) 10, relié au réseau électrique 12. Cette représentation est simplifiée, car une chaine comporte en général plus de 3 modules. En outre, une installation peut comporter plusieurs chaines 100, 101, ... en parallèle, comme illustré en figure 1B.

Un arc électrique parallèle peut se produire aux bornes de plusieurs chaines, par exemple entre les points A et B de la figure 1B, entre les modules photovoltaïques et l'onduleur 10, ces 2 points A et B étant à des potentiels différents.

On cherche donc à développer des systèmes permettant de détecter un arc électrique parallèle aux bornes principales d'une installation photovoltaïque dès son apparition, afin de l'interrompre et de limiter le plus possible son influence sur l'installation et son environnement.

Des solutions connues de détection d'arcs électriques dans les installations basse tension en courant continu ou alternatif sont principalement basées sur une détection ultrasonore (par signature acoustique de l'arc) ou radiofréquence (par signature RF de l'arc) ou encore sur des mesures thermiques (signature infrarouge de l'arc). La signature d'un phénomène est l'ensemble des caractéristiques et de leurs valeurs qui permet de l'identifier de façon certaine.

Pour les installations PV, le même type de détecteur commence à être développé par certains laboratoires ou industriels.

La principale contrainte de ces systèmes repose sur leur moyen de mesure de la signature. En effet, les signatures étant complexes et généralement à des fréquences élevées (pour les signatures acoustiques et RF) elles nécessitent un traitement logiciel très lourd, avec un échantillonnage élevé, et donc des composants coûteux. De plus, le temps de traitement, incluant une discrimination du bruit ou des perturbations par rapport à la signature de l'arc, peut être élevé, allant de quelques secondes à quelques minutes.

Ces solutions ne répondent donc pas à un besoin de mise en sécurité rapide, fiable et à bas coût.

On connait des méthodes pour détecter des arcs électriques série dans un système PV, mais ces méthodes ne sont pas adaptées pour détecter des arcs parallèles, en particulier aux bornes principales d'une installation photovoltaïque.

Par exemple, le document FR 2912848 décrit comment détecter un arc série en utilisant la mesure d'une variation rapide de la tension.

Le document WO 2011/17721 décrit une méthode basée sur une mesure moyenne du courant, dont l'évolution est observée. Cette solution nécessite une mesure longue et un traitement long.

Le document WO 2011/11711 décrit une méthode basée sur une comparaison d'une signature de courant et d'une signature de tension sur un convertisseur de puissance pour module photovoltaïque. Le fait de devoir comparer le courant et la tension implique une puissance de calcul et des moyens de mesure évolués, donc coûteux.

On connait d'autres techniques pour détecter un arc, mais elles ne sont pas nécessairement compatibles avec des dispositifs fonctionnant en continu. Ainsi, le document US2008/180866 traite d'une détection d'arcs électriques sur une installation AC par mesure de courant. Son enseignement n'est pas applicable au cas d'une installation qui peut éventuellement fonctionner en courant continu, comme dans le cas d'une installation photovoltaïque.

Le document US 2010/085669 traite d'un détecteur d'arcs électriques basé sur un traitement logiciel et mathématique d'un signal de courant qui est amplifié et converti en valeurs numériques. Cette approche ne permet pas de répondre à un traitement rapide et simple.

US 6 504 692 évoque une méthode de détection des arcs électriques parallèles pour les systèmes AC. Cette détection est basée sur des variations de tension. Mais les paramètres de variation (amplitude, fréquence, temps de montée/descente...) ne sont pas les mêmes sur la partie DC d'une installation photovoltaïque.

L'enseignement de ce document n'est donc pas applicable au problème posé ici, qui est de trouver une méthode de caractérisation d'arcs électriques parallèles se produisant aux bornes d'une installation photovoltaïque, y compris dans le cas d'un fonctionnement en courant continu.

En outre, les solutions proposées dans ce document sont complexes.

Or une solution à ce problème doit de préférence être rapide et simple, sans mettre en oeuvre des moyens coûteux.

L'enseignement de ce document n'est donc pas applicable au problème posé ici, qui est de trouver une méthode de caractérisation d'arcs électriques parallèles se produisant aux bornes principales d'une installation photovoltaïque.

Une solution à ce problème doit de préférence être rapide et simple, sans mettre en oeuvre des moyens couteux.

### EXPOSÉ DE L'INVENTION

On décrit ici un procédé de détection d'un arc parallèle dans un dispositif photovoltaïque, comportant N (N=1 ou N>1) modules photovoltaïques, reliés à un dispositif de charge présentant un comportement capacitif pour les modules, ce procédé comportant :
a) détecter, aux bornes principales dudit dispositif, l'évolution temporelle de la tension, au moins lors de la formation de l'arc électrique,
b) identifier une variation négative, ou de sens négatif, de la tension, entre une première zone (R₁), pendant laquelle la tension présente une pente sensiblement stable et une deuxième zone (R₂), pendant laquelle la tension présente une pente sensiblement stable pendant une durée d'au moins 5µs, qui suit immédiatement ladite variation de tension, et
c) déterminer si la variation de tension est comprise entre une valeur maximum Vmax, supérieure ou égale à 100 V, et une valeur minimum Vmin, inférieure ou égale à 30 V, avec un temps de descente de cette variation compris entre une durée minimum Tmin supérieure ou égale à 0,01 µs et une durée maximum Tmax inférieure ou égale à 10 µs.

Selon un mode de réalisation, l'étape de détermination c) est réalisée :
- d'une part par analyse de la pente de la variation de tension en déterminant si cette pente est comprise entre :
   * une valeur minimum, donnée par le rapport Vmin/Tmax,
   * et une valeur maximum, donnée par le rapport Vmax/Tmin,
- et, d'autre part, en déterminant si la variation de tension est comprise entre une valeur minimum Vmin inférieure ou égale à 30 V, et une valeur maximum Vmax supérieure ou égale à 100 V, ou si le temps descente de cette variation compris entre une durée minimum Tmin supérieure ou égale à 0,01 µs et une durée maximum Tmax inférieure ou égale à 10 µs.

Avantageusement on réalise un filtrage passif et/ou actif de l'évolution temporelle de la tension.

L'évolution temporelle de la tension peut être numérisée, les étapes a) à c) étant réalisées à partir de valeurs numériques de la tension.

Le dispositif de charge peut comporter un convertisseur ou un onduleur ou une batterie.

Selon une application particulière, le courant est continu.

L'invention concerne également un dispositif de détection d'un arc parallèle dans un dispositif photovoltaïque, comportant N (N=1 ou N>1) modules photovoltaïques, reliés à un dispositif de charge présentant un comportement capacitif pour les modules, ce dispositif comportant :
a) des moyens pour détecter, aux bornes principales (A, B) dudit dispositif, l'évolution temporelle de la tension, au moins lors de la formation de l'arc électrique,
b) des moyens pour identifier une variation négative, ou de sens négatif, de la tension entre une première zone (R₁), pendant laquelle la tension présente une pente sensiblement stable et une deuxième zone (R₂), pendant laquelle la tension présente une pente sensiblement stable pendant une durée d'au moins 5µs, qui suit immédiatement ladite variation de tension, et
c) des moyens pour déterminer si la variation de tension est comprise entre une valeur maximum Vmax, supérieure ou égale à 100 V, et une valeur minimum Vmin, inférieure ou égale à 30 V, avec un temps de descente de cette variation compris entre une durée minimum Tmin supérieure ou égale à 0,01 µs et une durée maximum Tmax inférieure ou égale à 10 µs.

Selon un mode de réalisation lesdits moyens déterminant si la variation de tension est comprise entre ladite valeur maximum Vmax et ladite valeur minimum Vmin, avec un temps de descente de cette variation compris entre Tmin et Tmax :
- analysent d'une part de la pente de la variation de tension, en déterminant si cette pente est comprise entre :
   * une valeur minimum, donnée par le rapport Vmin/Tmax,
   * et une valeur maximum, donnée par le rapport Vmax/Tmin,
- et, d'autre part, déterminent si la variation de tension est comprise entre une valeur minimum Vmin inférieure ou égale à 30 V, et une valeur maximum Vmax supérieure ou égale à 100 V, ou si le temps de descente de cette variation compris entre une durée minimum Tmin supérieure ou égale à 0,01 µs et une durée maximum Tmax inférieure ou égale à 10 µs.

Un tel dispositif peut avantageusement comporter des moyens pour filtrer des fréquences au moins égales à 100Hz.

Des moyens de filtrage passif et/ou actif de l'évolution temporelle de la tension peuvent être prévus.

De préférence, un tel dispositif comporte des moyens de filtrage analogiques et numériques.

Des moyens peuvent être prévus pour numériser les tensions mesurées.

Le dispositif présentant un comportement capacitif pour les modules peut comporter un convertisseur ou un onduleur ou une batterie.

### BREVE DESCRIPTION DES FIGURES

- Les figures 1A et 1B représentent schématiquement des installations photovoltaïques de type connu,
- la figure 1C représente schématiquement une structure générale d'une installation photovoltaïque, avec des moyens de détection d'arc parallèle, positionnés entre module photovoltaïque et convertisseur,
- les figures 2A et 2B représentent les variations d'une tension, au cours du temps, lors d'un arc électrique parallèle aux bornes d'un dispositif photovoltaïque, la tension filtrée étant en outre représentée en figure 2B,
- la figure 3 - 5 représentent divers modes de réalisation d'un dispositif selon l'invention.
- la figure 6 représente des courbes courant/tension caractéristiques d'un module photovoltaïque,
- la figure 7 représente une portion d'un signal sinusoïdal, par exemple dans le cas d'un onduleur induisant des perturbations,

### EXPOSÉ DÉTAILLÉ DE MODES DE RÉALISATION PARTICULIERS

La figure 1C représente schématiquement la structure d'une installation photovoltaïque (on utilise également l'abréviation PV dans le reste de cette description), comportant 2 chaines 100, 101 de modules photovoltaïques 100₁, 100₂, 100₃, 101₁, 101₂, 101₃, les différents modules 100₁ - 100₃, 101₁ - 101₃ d'une même chaîne étant reliés en série. On appelle module photovoltaïque un assemblage monolithique de cellules photovoltaïques.

La présente description n'est pas limitée à une ou deux chaines comportant chacune trois modules photovoltaïques, mais s'applique à un nombre n_{mod} quelconque de ces modules dans une chaine et/ou à un nombre N_{c} quelconque de chaines.

Un élément 10 impose une charge capacitive à la sortie de l'installation, ou encore présente un comportement capacitif pour les modules, tel qu'un convertisseur ou un onduleur ou une batterie.

Cet élément 10 est relié au réseau électrique 12.

Grâce à leur capacité d'entrée, ou à leur charge d'entrée de nature capacitive, les moyens 10 permettent, pendant la durée d'établissement d'un arc, de maintenir une tension stable en sortie des chaînes de modules PV. Comme déjà indiqué ci-dessus, en variante, on peut prévoir un onduleur, ou une charge capacitive telle qu'un convertisseur ou une batterie, qui permettra le même effet de stabilisation.

Un arc électrique parallèle peut se produire entre les bornes principales A, B, qui ont des polarités différentes, comme représenté en figure 1B. Chacune des bornes principales A, B est à la même tension que l'une des 2 extrémités de chacune des chaines (en d'autres termes : chaque extrémité d'une chaine est au même potentiel que l'une des 2 bornes principales). Une extrémité d'une chaîne est reliée à un seul module de la chaîne, qui est le module de cette extrémité.

La référence 8 désigne des moyens qui permettent de mesurer la tension entre les bornes A, B auxquelles ils sont reliés. Ces moyens 8 vont permettre d'identifier, par la mesure de la tension, le déclenchement d'un arc électrique parallèle. Cette mesure de tension correspond aussi à une mesure de tension aux bornes d'une ou plusieurs chaines.

La tension et le courant débités par les modules photovoltaïques dépendent de plusieurs paramètres (ensoleillement, température), et peuvent varier d'une façon importante.

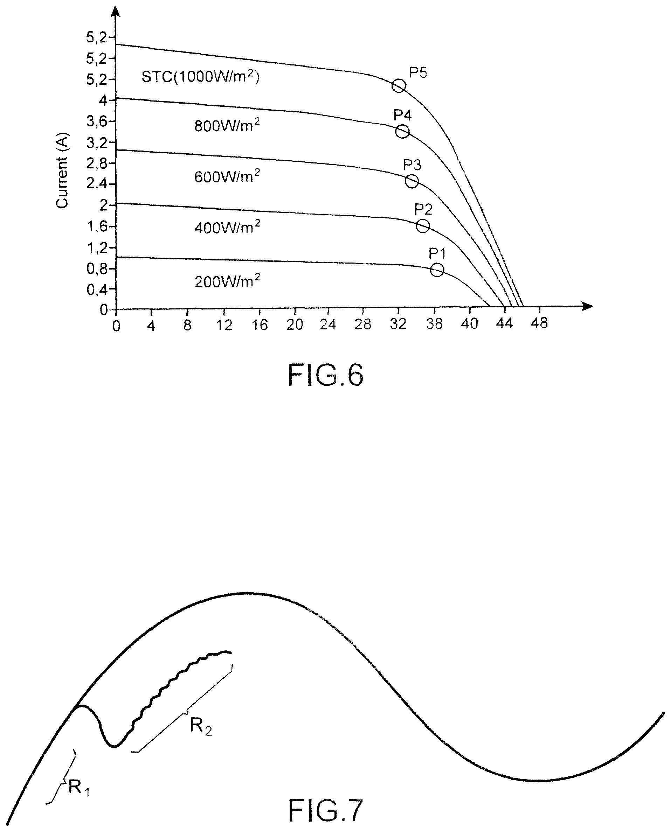

La figure 6 montre des courbes caractéristiques d'un module photovoltaïque en fonction de l'éclairement reçu (de 200 à 1000W/cm2). Le courant débité par le module varie fortement en fonction de cet éclairement (proportionnellement dans une première approximation). Les points de fonctionnement P1, P2,...Pk sur les courbes de la figure 6 sont les points où le module délivre le maximum de puissance pour un éclairement donné.

Afin d'optimiser la production d'énergie, le convertisseur ou l'onduleur 10 impose une tension de fonctionnement des modules de façon à ce que ces derniers produisent le maximum de puissance (cette fonction est appelée : MPPT = « maximum power point tracking »).

Lorsqu'un arc se produit, la valeur finale minimale, de la tension d'arc V_{arc}, est d'environ 10V. Elle est liée aux caractéristiques physiques d'un arc électrique. En effet, comme d'ailleurs déjà expliqué dans le document FR 2 912 848, un arc électrique peut être décomposé en 3 zones :
- 1 zone d'interface électrode/air
- 1 zone de plasma
- 1 zone d'interface air/électrode.

Les deux zones d'interface se présentent comme une jonction PN d'une diode, à savoir une jonction entre un matériau conducteur et un isolant.

Cette jonction présente donc un potentiel fixe qui est directement lié aux potentiels des matériaux en présence. Celui de l'air ne varie pas, en revanche celui de l'électrode peut varier suivant que l'électrode est en cuivre, ou en aluminium, ou en argent... Ce potentiel est donc présent à chaque interface et est caractéristique de l'arc. Il apparaît dès l'amorçage (avant établissement du plasma) et sa valeur V_{arc}, mesurée aux bornes de l'arc, est comprise entre 10V et 25V ou même 30 V.

A partir de la mesure de la tension par les moyens 8, une signature caractéristique d'un arc électrique parallèle peut être identifiée. Ce type d'arc électrique se traduit en effet par une baisse rapide de la tension.

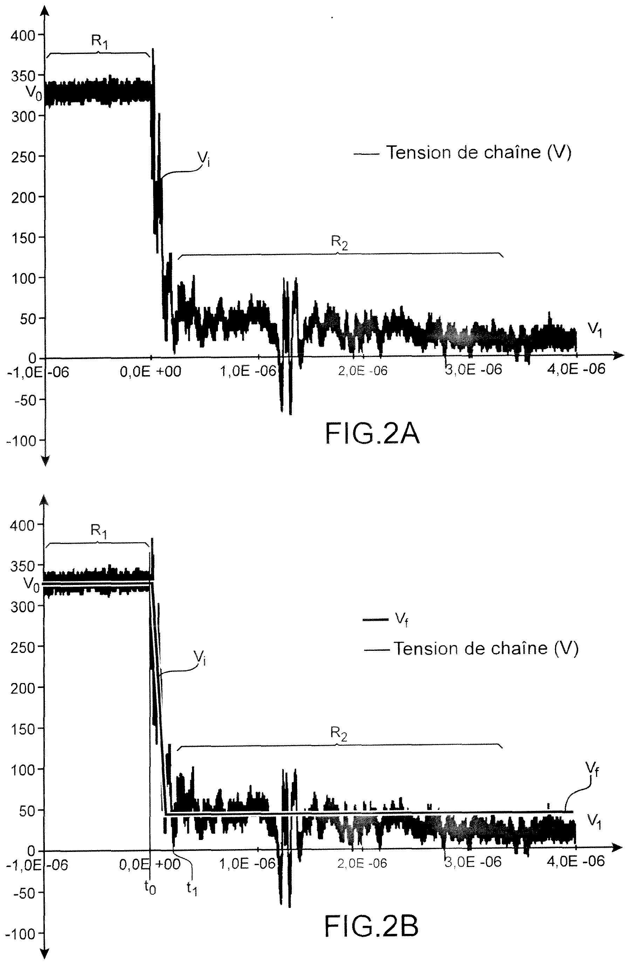

L'évolution de la tension instantanée Vᵢ, d'un arc électrique parallèle présente de fortes oscillations et peut prendre la forme représentée en figure 2A. Est également représentée (figure 2B) la tension V_{f}, qui résulte d'un filtrage de la tension instantanée Vᵢ. On note que les variations de tension se produisent entre une 1^{ère} zone de stabilité en tension (zone R₁ sur les figures 2A et 2B), à une valeur de tension V₀ dite valeur initiale, et une 2^{ème} zone de stabilité en tension (zone R₂ sur les figures 2A et 2B), à une valeur V_{arc}, valeur finale de la tension d'arc. Cette 2^{ème} zone de stabilité a une durée d'au moins quelques µs, par exemple au moins 5 µs ou au moins 10 µs. Les oscillations observées dans les zones R₁ et R₂ sont principalement dues à la mesure.

Globalement, on observe une chute très nette de la tension mesurée.

Malgré des oscillations de tension variables, observées au début du front de la tension instantanée Vᵢ, la signature d'un arc électrique parallèle entre les points A et B se caractérise, entre la 1^{ère} zone de stabilité en tension et la 2^{ème} zone de stabilité en tension, par une évolution négative ΔV (= V_{arc} - V₀) de la tension Vᵢ (mais, également, de V_{f}, puisque celle-ci est directement déduite de Vᵢ, par lissage de la courbe Vᵢ) d'une valeur absolue comprise entre 1500 V et 10 V. Dans l'exemple des figures 2A et 2B, la valeur absolue de ΔV est d'environ 350 V.

Un autre paramètre d'un arc électrique parallèle du type étudié ici, dans un système photovoltaïque, est le temps de descente ΔT de la variation négative de la signature de l'arc électrique (de t₀ à t₁ sur la courbe II de la figure 2B, t₀ identifiant l'instant considéré comme le début de l'arc, t₁ identifiant l'instant considéré comme la fin de l'arc). ΔT est mesuré entre la valeur initiale V₀ de la tension et la valeur finale V₁ (de Vf), avec une marge d'erreur, par exemple + 10%, cette marge d'erreur étant due au bruit sur la forme d'onde. Ce temps de descente est lié aux caractéristiques physiques des modules photovoltaïques et à leur comportement dynamique. Un module photovoltaïque représente une certaine valeur de capacité parasite variable. Il possède donc un temps de réponse à un échelon de tension qui lui est caractéristique. Mais ce temps varie peu selon les différentes technologies de modules photovoltaïques.

Il peut être par exemple compris entre 0,01 µs et 10 µs, pour une mesure de la variation de tension entre les bornes A et B.

Ces spécificités permettent d'identifier, entre 2 zones de stabilité de la tension, la signature d'un arc électrique parallèle aux bornes principales d'une installation photovoltaïque.

Mesurée entre les bornes A et B (donc avec des moyens de détection positionnés comme représenté en figure 1C), la tension passera d'une valeur de V_{MPP} (différence de tension initiale entre A et B), par exemple d'environ 350V, à une valeur V_{arc} comprise entre 10 et 30V en un temps t_{arc} compris entre 0.01 µs et 10 µs, soit une valeur maximale de la pente de cette variation de tension (dans le cas où V_{MPP} = 350V) comprise entre environ 30000 V/µs et 35000 V/µs et une valeur minimale (pour V_{MPP} = 350 V) comprise entre environ 300 V/µs et 350 V/µs.

Pour une valeur autre de VMPP :
- la valeur maximale de la pente de cette variation de tension sera comprise entre environ (V_{MPP} -30) V x 10²/µs et (V_{MPP} -10) V x 10²/µs ;
- la valeur minimale de la pente de cette variation de tension sera comprise entre environ (V_{MPP} -30) V x 0,1/µs et (V_{MPP} -10) V x 0,1/µs ;

Plus généralement, on peut caractériser un arc parallèle entre les points A et B :
- par la durée ΔT et la pente de la variation de tension lors de son évolution temporelle ;
- ou par la variation de tension ΔV et la pente de la variation de tension lors de son évolution temporelle,
- ou par une variation de tension ΔV et la durée ΔT.

La présence d'un arc se traduit donc :
- par une variation de tension maximale comprise entre environ 1500 V et 100 V, avec un temps de descente compris entre 0,01 µs et 10 µs ;
- ou par une pente du front de tension comprise entre 1,5x10⁵ V/µs et 10 V/µs, avec un temps de descente compris entre 0,01 µs et 10 µs ;
- ou par une pente du front de tension comprise entre 1,5x10⁵ V/µs et 10 V/µs, avec une variation de tension maximale comprise entre 1500 V et 100 V.

En d'autres termes, on détermine, d'une manière ou d'une autre, si la variation de tension est comprise entre environ 1500 V et 100 V, avec un temps de descente de cette variation compris entre une durée Tmin supérieure ou égale à 0,01 µs et une durée Tmax inférieure ou égale à 10 µs.

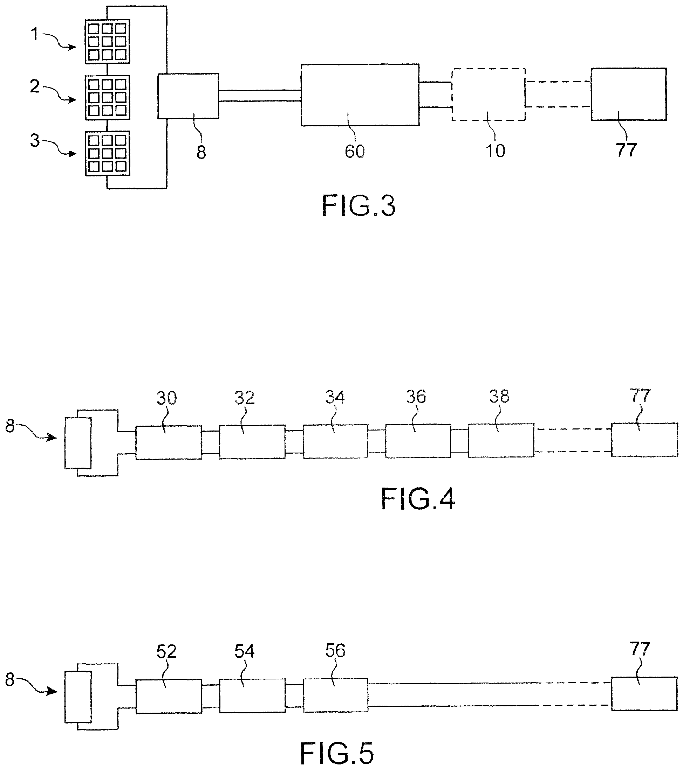

Des moyens 77 (figures 3-5) de traitement de données, spécialement programmés à cet effet pourront permettre d'analyser les valeurs de tension mesurées pour établir la présence d'un arc parallèle. Ces moyens 77 peuvent par exemple comporter un microprocesseur ou un ordinateur.

L'invention a été décrite ci-dessus dans le cas d'un courant continu, les moyens 10 permettant de maintenir une tension stable en sortie des chaînes de modules PV. Cependant, l'onduleur 10 peut induire des perturbations, auquel cas il en résulte une tension variable, sinusoïdale, à une fréquence par exemple égale à 100 Hz.

L'enseignement de la présente invention reste applicable à ce type de situation.

Une partie du signal sinusoïdal correspondant est représenté en figure 7.

Une variation de tension décrite ci-dessus se retrouve sur un tel signal, entre des portions du signal qui présentent des pentes sensiblement stables.

Ainsi, la variation qui a été décrite ci-dessus en liaison avec les figures 2A et 2B se retrouve ici entre une portion R₁ du signal qui présente une pente positive sensiblement constante et une autre portion R₂ du signal qui présente elle aussi une pente positive sensiblement constante. On ferait un raisonnement similaire si l'arc se produisait dans une portion décroissante du signal sinusoïdal, la variation de tension se produisant alors entre une portion du signal qui présente une pente négative sensiblement constante et une autre portion du signal qui présente elle aussi une pente négative sensiblement constante.

Pour ces raisons, l'invention peut en outre également s'appliquer au cas d'un système fonctionnant en courant alternatif.

Des exemples de réalisation d'un dispositif pour détecter un arc mettent en oeuvre des moyens techniques permettant de faire l'acquisition du signal et de discriminer une signature du type décrite ci-dessus.

Pour cela, différentes solutions techniques sont possibles.

Un exemple de réalisation d'un tel dispositif est illustré en figure 3 : il s'agit d'une réalisation en mode numérique, utilisant une chaîne d'acquisition, comportant les moyens 8 formant détecteur d'arcs et un convertisseur analogique/numérique 60 qui permet de différencier la signature des autres bruits ambiants. Ce mode de réalisation numérique ne nécessite pas de filtrage. Selon le procédé de calcul utilisé, le convertisseur 60 permet d'échantillonner le signal à une fréquence comprise entre 100 kHz et 5 MHz. Un échantillonnage au voisinage de 100 kHz donc à basse fréquence, est très avantageux en termes de coût. Avantageusement, la fréquence d'échantillonnage est comprise entre 90 kHz et 600 kHz. Des moyens de traitement numérique permettent de calculer les différentes valeurs et de mettre en oeuvre les étapes de traitement selon l'invention.

Des moyens 77 de traitement de données, spécialement programmés à cet effet, pourront permettre de mémoriser et/ou d'analyser les valeurs de tension mesurées pour établir la présence d'un arc parallèle. Ces moyens 77 peuvent par exemple comporter un microprocesseur ou un ordinateur.

D'autres solutions techniques, de type analogique, sont possibles. On cherche alors à isoler la tension mesurée, ou la signature de l'arc électrique, des autres perturbations de la tension observées à l'entrée des moyens de détection de tension. En effet, sur un système PV la tension n'est pas parfaitement lisse, il demeure des perturbations, en particulier à 100Hz, de forme sinusoïdale et d'amplitude variable suivant le niveau de puissance injecté par l'onduleur 10 sur le réseau : ce sont des harmoniques générées par l'onduleur, qui se reportent à son entrée et donc sur la partie continue de l'installation PV. Certaines perturbations peuvent être à plus haute fréquence, par exemple des perturbations de type Dirac, qui représentent des perturbations de démarrage moteur ou de tout autre élément proche de l'installation PV et émettant des perturbations électromagnétiques. Par exemple, un moteur peut se trouver dans un environnement proche de l'installation PV et émettre un champ électromagnétique perturbateur ou être alimenté par la sortie de l'onduleur.

Enfin, des perturbations liées à l'utilisation d'une communication par courant porteur en ligne (CPL) peuvent gêner les moyens de détection de la tension. Ces perturbations peuvent provenir, par exemple, de la présence, dans l'installation PV, de systèmes intelligents et communiquant par courant porteur en ligne (CPL).

Un exemple de réalisation analogique consiste en l'utilisation de filtres passifs analogiques en cascade, comme illustré en figure 4. Sur cette figure, comme sur la suivante, la référence 8 désigne les moyens de mesure de tension de la figure 1C .

Dans cet exemple, le circuit comporte 3 étages : un 1^{er} filtre passif 30 (passe bande), un 2^{ème} filtre passif 32 (passe haut) et un amplificateur 34.

Ces étages peuvent être regroupés en 1 seul. Ces étages peuvent être suivis d'un buffer 36 et de moyens 38 de découplage, pour découpler le module PV du circuit électrique afin de le mettre en sécurité. Le buffer permet de filtrer les rebonds du signal mesuré. Un arc électrique est rarement franc et est constitué d'une multitude d'amorçages avant de stabiliser son plasma : il convient de détecter seulement le premier amorçage.

Les filtres 30, 32 permettent d'isoler la bonne fréquence (avec le temps caractéristique de montée ou de descente ayant les valeurs indiquées précédemment) et donc de rejeter les basses fréquences (de préférence en dessous de 1000 Hz) et les hautes fréquences.

Ce filtrage peut aussi être effectué avec des éléments actifs permettant d'en augmenter la sélectivité (ordre 6 au lieu de l'ordre 1 ou 2 avec le filtrage passif). Le dispositif comporte alors des moyens formant filtre actif (passe haut), des moyens formant amplificateur et comparateur, des moyens formant filtre passif (passe bas), des moyens formant filtre passif (passe bas), un buffer, et des moyens de découplage.

Enfin, une combinaison de moyens analogiques et de moyens numériques est possible, comme illustré en figure 5, comportant :
- des moyens 52 de découplage,
- des moyens 54 formant amplificateur et comparateur,
- des moyens 56 de traitement numérique.

D'autres modes de réalisation sont possibles, par exemple les fonctions d'amplification et de comparaison ne sont pas nécessairement dans un même dispositif 54.

Dans les divers dispositifs analogiques décrits, on détecte la variation de tension et le temps caractéristique (de descente) correspondant, et en particulier :
- grâce au comparateur, pour la variation de tension,
- grâce à la sélectivité des filtres, le temps de montée ou de descente de cette variation, compris entre 0,01 µs et 10 µs (cas d'un arc parallèle) ou entre 0,5 µs et 5 µs (cas d'un arc série).

Globalement, plus on privilégie un système numérique, plus le temps de réponse du dispositif est rapide. Il est intéressant d'avoir un temps de réponse rapide (de quelques dizaines de microsecondes) car il est ainsi possible de limiter l'apparition du plasma d'arc, évitant ainsi des dégradations physiques sur le système. Plus le nombre de composants pour réaliser la fonction est réduit, plus le coût sera réduit, d'où l'intérêt de ne travailler que sur la signature en tension et en analogique (pas en courant ou en RF et avec un traitement numérique lourd derrière).

## Revendications

1. Procédé de détection d'un arc parallèle dans un dispositif photovoltaïque, comportant N (N=1 ou N>1) modules photovoltaïques (100₁, 100₂, 100₃, 101₁, 101₂, 101₃), reliés à un dispositif de charge (10) présentant un comportement capacitif pour les modules, ce procédé comportant :
a) détecter, aux bornes principales (A, B) dudit dispositif, l'évolution temporelle de la tension,
b) identifier une variation négative de tension entre une première zone (R1), pendant laquelle la tension présente une pente sensiblement stable et une deuxième zone (R2), pendant laquelle la tension présente une pente sensiblement stable pendant une durée d'au moins 5µs, qui suit immédiatement ladite variation de tension, et
c) déterminer si la variation de tension est comprise entre une valeur maximum Vmax, supérieure ou égale à 100 V, et une valeur minimum Vmin, inférieure ou égale à 30 V, avec un temps de descente de cette variation compris entre une durée minimum Tmin supérieure ou égale à 0,01 µs et une durée maximum Tmax inférieure ou égale à 10 µs.

2. Procédé selon la revendication 1, dans lequel l'étape de détermination c) est réalisée :
- d'une part par analyse de la pente de la variation de tension en déterminant si cette pente est comprise entre :
* une valeur minimum, donnée par le rapport Vmin/Tmax,
* et une valeur maximum, donnée par le rapport Vmax/Tmin,
- et, d'autre part, en déterminant si la variation de tension est comprise entre une valeur minimum Vmin inférieure ou égale à 30 V, et une valeur maximum Vmax supérieure ou égale à 100 V, ou si le temps de descente de cette variation est compris entre une durée minimum Tmin supérieure ou égale à 0,01 µs et une durée maximum Tmax inférieure ou égale à 10 µs.

3. Procédé selon la revendication 1 ou 2, dans lequel on réalise un filtrage passif et/ou actif de l'évolution temporelle de la tension.

4. Procédé selon l'une des revendications 1 à 3, dans lequel l'évolution temporelle de la tension est numérisée, les étapes a) à c) étant réalisées à partir de valeurs numériques de la tension.

5. Procédé selon l'une des revendications 1 à 4, dans lequel le dispositif de charge (10) comporte un convertisseur ou un onduleur ou une batterie.

6. Procédé selon l'une des revendications 1 à 5, dans lequel le courant est continu.

7. Dispositif de détection d'un arc parallèle dans un dispositif photovoltaïque, comportant N (N=1 ou N>1) modules photovoltaïques (100, 1, 2, 3), reliés à un dispositif de charge (10) présentant un comportement capacitif pour les modules, ce dispositif comportant :
a) des moyens (8) pour détecter, aux bornes principales (A, B) dudit dispositif, l'évolution temporelle de la tension,
b) des moyens (8, 77) pour identifier une variation négative de tension entre une première zone (R1), pendant laquelle la tension présente une pente sensiblement stable et une deuxième zone (R2), pendant laquelle la tension présente une pente sensiblement stable pendant une durée d'au moins 5µs, qui suit immédiatement ladite variation de tension, et
c) des moyens (8, 77) pour déterminer si la variation de tension est comprise entre une valeur maximum Vmax, supérieure ou égale à 100 V, et une valeur minimum Vmin, inférieure ou égale à 30 V, avec un temps de descente de cette variation compris entre une durée minimum Tmin supérieure ou égale à 0,01 µs et une durée maximum Tmax inférieure ou égale à 10 µs.

8. Dispositif selon la revendication 7, lesdits moyens (8, 77) déterminant si la variation de tension est comprise entre ladite valeur maximum Vmax et ladite valeur minimum Vmin, avec un temps de descente de cette variation compris entre Tmin et Tmax :
- d'une part par analyse de la pente de la variation de tension, en déterminant si cette pente est comprise entre :
* une valeur minimum, donnée par le rapport Vmin/Tmax,
* et une valeur maximum, donnée par le rapport Vmax/Tmin,
- et, d'autre part, en déterminant si la variation de tension est comprise entre une valeur minimum Vmin inférieure ou égale à 30 V, et une valeur maximum Vmax supérieure ou égale à 100 V, ou si le temps de descente de cette variation est compris entre une durée minimum Tmin supérieure ou égale à 0,01 µs et une durée maximum Tmax inférieure ou égale à 10 µs.

9. Dispositif selon l'une des revendications 7 ou 8, comportant des moyens pour éliminer de l'évolution temporelle de la tension les fréquences au moins égales à 100Hz.

10. Dispositif selon l'une des revendications 7 à 9, comportant en outre des moyens (30, 32, 40, 44) de filtrage passif et/ou actif de l'évolution temporelle de la tension.

11. Dispositif selon l'une des revendications 7 à 10, comportant des moyens de filtrage analogiques et numériques (50, 52, 54) de l'évolution temporelle de la tension.

12. Dispositif selon l'une des revendications 7 à 11, comportant des moyens (60) pour numériser les tensions mesurées.

13. Dispositif selon l'une des revendications 7 à 12, dans lequel le dispositif (10) présentant un comportement capacitif pour les modules comporte un convertisseur ou un onduleur ou une batterie.

## Patentansprüche

1. Verfahren zur Detektion von einem parallelen Lichtbogen in einer Fotovoltaikeinrichtung, umfassend N (N = 1 oder N > 1) Fotovoltaikmodule (100₁, 100₂, 100₃, 101₁, 101₂, 101₃), die mit einer Ladungseinrichtung (10) verbunden sind, welche für die Module ein kapazitives Verhalten aufweist, wobei das Verfahren umfasst:
a) Erfassen der zeitlichen Entwicklung der Spannung an den Hauptanschlüssen (A, B) der Einrichtung,
b) Identifizieren einer negativen Spannungsvariation zwischen einem ersten Bereich (R1), während dessen die Spannung eine im Wesentlichen stabile Steigung aufweist, und einem zweiten Bereich (R2), während dessen die Spannung eine im Wesentlichen stabile Steigung während einer Dauer von wenigstens 5 µs aufweist, der unmittelbar auf die Spannungsvariation folgt, und
c) Bestimmen, ob die Spannungsvariation zwischen einem Maximalwert Vmax, der größer oder gleich 100 V ist, und einem Minimalwert Vmin liegt, der kleiner oder gleich 30 V ist, wobei eine Abnahmezeit dieser Variation zwischen einer Minimaldauer Tmin, die größer oder gleich 0,01 µs ist, und einer Maximaldauer Tmax liegt, die kleiner oder gleich 10 µs ist.

2. Verfahren nach Anspruch 1, wobei der Schritt des Bestimmens c) ausgeführt wird:
einerseits durch Analyse der Steigung der Spannungsvariation, indem bestimmt wird, ob diese Steigung zwischen
einem Minimalwert, der durch das Verhältnis Vmin/Tmax gegeben ist, und
einem Maximalwert liegt, der durch das Verhältnis Vmax/Tmin gegeben ist,
und andererseits durch Bestimmen, ob die Spannungsvariation zwischen einem Minimalwert Vmin, der kleiner oder gleich 30 V ist, und einem Maximalwert Vmax liegt, der größer oder gleich 100 V ist, oder ob die Abnahmezeit dieser Variation zwischen einer Minimaldauer Tmin, die größer oder gleich 0,01 µs ist, und einer Maximaldauer Tmax liegt, die kleiner oder gleich 10 µs ist.

3. Verfahren nach Anspruch 1 oder 2, wobei eine passive oder/und aktive Filterung der zeitlichen Entwicklung der Spannung durchgeführt wird.

4. Verfahren nach einem der Ansprüche 1 bis 3, wobei die zeitliche Entwicklung der Spannung digitalisiert wird und wobei die Schritte a) bis c) ausgehend von digitalen Werten der Spannung durchgeführt werden.

5. Verfahren nach einem der Ansprüche 1 bis 4, wobei die Ladungseinrichtung (10) einen Wandler oder einen Wechselrichter oder eine Batterie umfasst.

6. Verfahren nach einem der Ansprüche 1 bis 5, wobei der Strom kontinuierlich ist.

7. Vorrichtung zur Detektion von einem parallelen Lichtbogen in einer Fotovoltaikeinrichtung, umfassend N (N = 1 oder N > 1) Fotovoltaikmodule (100, 1, 2, 3), die mit einer Ladungseinrichtung (10) verbunden sind, welche für die Module ein kapazitives Verhalten aufweist, wobei die Vorrichtung umfasst:
a) Mittel (8), um an den Hauptanschlüssen (A, B) der Einrichtung die zeitliche Entwicklung der Spannung zu erfassen,
b) Mittel (8, 77), um eine negative Spannungsvariation zwischen einem ersten Bereich (R1), während dessen die Spannung eine im Wesentlichen stabile Steigung aufweist, und einem zweiten Bereich (R2) zu identifizieren, während dessen die Spannung eine im Wesentlichen stabile Steigung während einer Dauer von wenigstens 5 µs aufweist, der unmittelbar auf die Spannungsvariation folgt, und
c) Mittel (8, 77), um zu bestimmen, ob die Spannungsvariation zwischen einem Maximalwert Vmax, der größer oder gleich 100 V ist, und einem Minimalwert Vmin liegt, der kleiner oder gleich 30 V ist, wobei eine Abnahmezeit dieser Variation zwischen einer Minimaldauer Tmin, die größer oder gleich 0,01 µs ist, und einer Maximaldauer Tmax liegt, die kleiner oder gleich 10 µs ist.

8. Vorrichtung nach Anspruch 7, wobei die Mittel (8, 77) bestimmen, ob die Spannungsvariation zwischen dem Maximalwert Vmax und dem Minimalwert Vmin liegt, wobei eine Abnahmezeit dieser Variation zwischen Tmin und Tmax liegt:
einerseits durch Analyse der Steigung der Spannungsvariation, indem bestimmt wird, ob diese Steigung zwischen
einem Minimalwert, der durch das Verhältnis Vmin/Tmax gegeben ist, und
einem Maximalwert liegt, der durch das Verhältnis Vmax/Tmin gegeben ist, und
andererseits durch Bestimmen, ob die Spannungsvariation zwischen einem Minimalwert Vmin, der kleiner oder gleich 30 V ist, und einem Maximalwert Vmax liegt, der größer oder gleich 100 V ist, oder ob die Abnahmezeit dieser Variation zwischen einer Minimaldauer Tmin, die größer oder gleich 0,01 µs ist, und einer Maximaldauer Tmax liegt, die kleiner oder gleich 10 µs ist.

9. Vorrichtung nach einem der Ansprüche 7 oder 8, umfassend Mittel, um aus der zeitlichen Entwicklung der Spannung die Frequenzen zu eliminieren, die mindestens gleich 100 Hz sind.

10. Vorrichtung nach einem der Ansprüche 7 bis 9, umfassend weiterhin Mittel (30, 32, 40, 44) zur passiven oder/und aktiven Filterung der zeitlichen Entwicklung der Spannung.

11. Vorrichtung nach einem der Ansprüche 7 bis 10, umfassend analoge und digitale Filtermittel (50, 52, 54) für die zeitliche Entwicklung der Spannung.

12. Vorrichtung nach einem der Ansprüche 7 bis 11, umfassend Mittel (60), um die gemessenen Spannungen zu digitalisieren.

13. Vorrichtung nach einem der Ansprüche 7 bis 12, wobei die Einrichtung (10), die ein kapazitives Verhalten für die Module aufweist, einen Wandler oder einen Wechselrichter oder eine Batterie umfasst.

## Claims

1. Method for detecting a parallel arc in a photovoltaic device, comprising N (N=1 or N>1) photovoltaic modules (100₁, 100₂, 100₃, 101₁, 101₂, 101₃), connected to a charge device (10) having a capacitive behaviour for the modules, this method comprising:
a) detecting, across the main terminals (A, B) of said device, the evolution of the voltage over time,
b) identifying a negative voltage variation between a first zone (R₁), during which the voltage has a substantially stable slope and a second zone (R₂), during which the voltage has a substantially stable slope for a duration of at least 5 µs, which immediately follows said voltage variation, and
c) determining whether the voltage variation is comprised between a maximum value Vmax, greater than or equal to 100 V, and a minimum value Vmin, less than or equal to 30 V, with a fall time of this variation comprised between a minimum duration Tmin greater than or equal to 0.01 µs and a maximum duration Tmax less than or equal to 10 µs.

2. Method according to claim 1, wherein the determination step c) takes place:
- on the one hand by analysing the slope of the voltage variation and determining whether this slope is between:
* a minimum value, given by the ratio of Vmin/Tmax,
* and a maximum value, given by the ratio of Vmax/Tmin,
- and, on the other hand, by determining whether the voltage variation is comprised between a minimum value Vmin, less than or equal to 30 V, and a maximum value Vmax, greater than or equal to 100 V, or whether the fall time of this variation is comprised between a minimum duration Tmin greater than or equal to 0.01 µs and a maximum duration Tmax less than or equal to 10 µs.

3. Method according to claim 1 or 2, wherein passive and/or active filtering of the evolution of the voltage over time takes place.

4. Method according to one of claims 1 to 3, wherein the evolution of the voltage over time is digitised, whereby the steps a) to c) are performed based on digital voltage values.

5. Method according to one of claims 1 to 4, wherein the charge device (10) includes a converter, an inverter or a battery.

6. Method according to one of claims 1 to 5, wherein the current is a direct current.

7. Device for detecting a parallel arc in a photovoltaic device, comprising N (N=1 or N>1) photovoltaic modules (100, 1, 2, 3), connected to a charge device (10) having a capacitive behaviour for the modules, this device comprising:
a) means (8) for detecting, across the main terminals (A, B) of said device, the evolution of the voltage over time,
b) means (8, 77) for identifying a negative voltage variation between a first zone (R1), during which the voltage has a substantially stable slope and a second zone (R2), during which the voltage has a substantially stable slope for a duration of at least 5 µs, which immediately follows said voltage variation, and
c) means (8, 77) for determining whether the voltage variation is comprised between a maximum value Vmax, greater than or equal to 100 V, and a minimum value Vmin, less than or equal to 30 V, with a fall time of this variation comprised between a minimum duration Tmin greater than or equal to 0.01 µs and a maximum duration Tmax less than or equal to 10 µs.

8. Device according to claim 7, wherein said means (8, 77) determine whether the voltage variation is between said maximum value Vmax and said minimum value Vmin, with a fall time for this variation of between Tmin and Tmax:
- on the one hand by analysing the slope of the voltage variation and determining whether this slope is between:
* a minimum value, given by the ratio of Vmin/Tmax,
* and a maximum value, given by the ratio of Vmax/Tmin,
- and, on the other hand, by determining whether the voltage variation is comprised between a minimum value Vmin, less than or equal to 30 V, and a maximum value Vmax, greater than or equal to 100 V, or whether the fall time of this variation is comprised between a minimum duration Tmin greater than or equal to 0.01 µs and a maximum duration Tmax less than or equal to 10 µs.

9. Device according to one of claims 7 or 8, comprising means for removing the frequencies at least equal to 100 Hz from the evolution of the voltage over time.

10. Device according to one of claims 7 to 9, further comprising means (30, 32, 40, 44) for the passive and/or active filtering of the evolution of the voltage over time.

11. Device according to one of claims 7 to 10, comprising means (50, 52, 54) for the analogue and digital filtering of the evolution of the voltage over time.

12. Device according to one of claims 7 to 11, comprising means (60) for digitising the voltages measured.

13. Device according to one of claims 7 to 12, wherein the device (10) having a capacitive behaviour for the modules includes a converter, an inverter or a battery.
